# EUROPEAN PATENT APPLICATION

(11) **EP 4 184 600 A1**
(43) Date of publication of application: **24.05.2023**
(21) Application number: 21209862.8
(22) Date of filing: 23.11.2021
(51) Int. Cl.: H01L 45/00, H01L 49/00

(54) **A THREE-DIMENSIONAL STACKING ARRANGEMENT OF NANOSCOPIC DEVICES, A METHOD FOR FABRICATING THE SAME AND A USE OF THE SAME**

(71) Applicant: Max-Planck-Gesellschaft zur Förderung der Wissenschaften e.V., 80539 München (DE)
(72) Inventor: MANNHART, Jochen, 71032 Böblingen (DE)
(74) Representative: Lambsdorff & Lange Patentanwälte Partnerschaft mbB

(57) **Abstract**

A three-dimensional arrangement (100) of nanoscopic devices (10), the arrangement (100) comprises a scaffold structure (11); and a plurality of nanoscopic devices (10), the nanoscopic devices (10) being configured to exhibit a nonrecipro-cal transmission probability of electron quantum wave packets, wherein the nanoscopic devices (10) are attached to the scaffold structure (11), wherein a majority of the nanoscopic devices (10) are oriented with one and the same transmission direction of the electron quantum wave packets.

## Description

### TECHNICAL FIELD

The present disclosure describes a three-dimensional arrangement of nanoscopic devices, a method for fabricating the same, and a use of the same. Within the arrangement a large number of the nanoscopic devices is assembled together, wherein each of which is generating a small thermally-driven electric voltage or current, into a compound structure such that the electrical output of the entire structure scales approximately with the sum of the outputs of the individual nanoscopic devices.

### BACKGROUND

In the following description reference will be made to the following documents:
[Mannhart, 2018a] J. Mannhart, Journal of Superconductivity and Novel Magnetism 31, 1649 (2018)
[Mannhart, 2018b] J. Mannhart and D. Braak, Journal of Superconductivity and Novel Magnetism 31, 1649 (2018)
[Bredol, 2019] P. Bredol et al., arXiv:1912.11948v1 (2019)
[Mannhart, 2019] J. Mannhart et al., Physica E 109, 198-200 (2019)
[Mannhart, 2020] J. Mannhart, Journal of Superconductivity and Novel Magnetism 33, 249 (2020)
[Lettiere, 2020] B.R. Lettiere et al., ACS Appl. Nano Mater. 3, 77 2020
[Mannhart, 2021] J. Mannhart, H. Boschker, and P. Bredol, Nano Express 2, 014998 (2021)
[Bredol, 2021] P. Bredol et al., Phys. Rev. B 104, 115413 (2021)
[Mannhart_001] Patent Application published as WO 2019/166187
[Mannhart_002] Patent Application published as WO 2020/001822
[Mannhart_003] Patent Application published as WO 2020/053333
[Mannhart_004] Patent Application published as WO 2021/018515

In the publications [Mannhart, 2018a, b; 2019; 2020; 2021; Bredol, 2019] and in the patent applications [Mannhart_001] to [Mannhart_004] nanodevices and molecules, both from now called nanoelements or nanoscopic devices, are disclosed that by means of nonreciprocal transmission of electron quantum wave packets and by inelastic scattering processes convert heat into a difference of the electrochemical potentials of two contacts of the nanoelement. The heat is used to generate thermal electric noise in the nanoelements' contacts (Nyquist-Johnson noise), which is of order kT, where k is the Boltzmann constant and T the temperature. The generated difference of the electrochemical potentials is by several orders of magnitude smaller than the thermal noise.

It is therefore required that numerous (preferably > 10²⁰) nanoelements are electrically connected to generate a macroscopic electric output. The publication [Bredol 2019] shows, for example, a corresponding two-dimensional arrangement of such nanoelements.

A three-dimensional arrangement of nanodevices has been mentioned for the specific case that the nanodevices form unit cells of natural three-dimensional crystals [Bredol 2019]. However, further ways to form such arrangements are sought for those nanodevices that do not form natural crystals, or for those cases in which a natural crystal would not provide an optimal structure, because, for example, such a crystal would not provide for the optimal circuit connection of the nanodevices or would not provide an optimal thermal connection to an external heat bath.

The person skilled in the art recognizes additional features and advantages upon reading the following detailed description and upon giving consideration to the accompanying drawings.

The output power of a nanoelement is tiny, its energy scale is much smaller than kT. To obtain a device output with practical energies, say mW, W, or more, many nanoelements have to be electrically connected into an arrangement, observing the correct polarity of the nanoelements. Here a connection of a macroscopic number of nanoelements, say 10⁶ or larger is most useful. For device function it is also of significance that the individual nanoelements are thermally well connected to a heat bath outside the device. Therefore a way is sought to assemble the nanoelements in a three-dimensional arrangement, to connect them as described, and to couple them to an external heat bath.

### SUMMARY

According to a first aspect of the present disclosure a three-dimensional arrangement of nanoscopic devices comprises a scaffold structure and a plurality of nanoscopic devices, the nanoscopic devices being configured to exhibit a nonreciprocal transmission probability of electron quantum wave packets, in particular together with inelastic scattering processes, wherein the nanoscopic devices are attached to the scaffold structure, wherein the majority of the nanoscopic devices are oriented with one and the same transmission direction of the electron quantum wave packets. In technical terminology, a majority usually means more than 50%, although in the specific situation more than 70%, 80% or 90% should be aimed for.

Accordingly, the problem is solved by a local, microscopic assembly of the nanoelements on the microscopic scale on the surface of a second material that serves as a scaffold element. Such scaffold elements are combined to form a scaffold, a macroscopic, three-dimensional object that is optimized for the desired arrangement of the nanoelements. In some implementations, this scaffold itself may also serve the role of the thermal conductor. In other implementations, another three-dimensional structure of a third material may serve for this function.

The entire arrangement therefore comprises of a compound structure which comprises a large number of nanoscopic devices or nanoelements attached to a smaller number of scaffold elements that form a scaffold, electrical contacts to the outside, and, possibly, an object providing a thermal conduction path.

According to an embodiment of the three-dimensional arrangement of the first aspect, the scaffold structure comprises at least one scaffold element.

According to an embodiment of the three-dimensional arrangement of the first aspect, each one of the nanoscopic devices comprises at least two contacts and nonreciprocal transmission probability of electron quantum wave packets between the two contacts.

According to an embodiment of the three-dimensional arrangement of the first aspect, the occurrence of nonreciprocal transmission through two-terminal devices involves the following two conditions.
a) When wave packets are inserted by one contact into a nanodevice, wave packets spend a longer time in the device as compared to being inserted by the other contact.
b) Wave packets have a higher probability of passing through a nanodevice in one direction. For a situation characterized by thermal equilibrium, this device behaviour is comparable to the behaviour of a Maxwell demon.

The condition (b) works if the device obeys (a), and in addition inelastic scattering is present in the device as was shown in the patent applications [Mannhart_001] to [Mannhart_004] and in [Bredol, 2021].

According to an embodiment of the three-dimensional arrangement of the first aspect, almost each one of the nanoscopic devices is connected between two other nanoscopic devices.

According to an embodiment of the three-dimensional arrangement of the first aspect, each one of the nanoscopic devices being further configured to convert heat of the environment into a difference of the electrochemical potentials of the two contacts.

According to an embodiment of the three-dimensional arrangement of the first aspect, the two contacts comprise a first contact and a second contact, and the three-dimension arrangement further comprises a non-reciprocal transmission structure connected between the two contacts and is configured to transmit the electron quantum wave packets in at least a partially phase-coherent manner from the first contact to the second contact, and possibly from the second contact to the first contact.

According to an embodiment of the three-dimensional arrangement of the first aspect, a time-reversal symmetry of the transmission of the electron quantum wave packets is broken with respect to at least a portion of the transmission structure.

According to an embodiment of the three-dimensional arrangement of the first aspect, the time-reversal symmetry is broken in such a way that the transmission structure comprises a higher transmission probability for particles moving in a first direction from the first terminal to the second terminal than in a second direction from the second terminal to the first terminal.

According to an embodiment of the three-dimensional arrangement of the first aspect, the nonreciprocal transmission is present without the external application of a voltage or a current to one or both of the first and second terminals.

According to an embodiment of the three-dimensional arrangement of the first aspect, the three-dimensional arrangement further comprises at least two electrical contacts connected to sides of the scaffold structure opposite to each other.

According to an embodiment of the three-dimensional arrangement of the first aspect, the scaffold structure comprises 10⁶ or more, preferably 10¹⁵ or more nanoscopic devices.

According to an embodiment of the three-dimensional arrangement of the first aspect, the scaffold structure comprises one or more of a plurality of fibres or nanotubes, a plurality of sheets or foils, a plurality of graphene layers, or a plurality of semiconductor carriers.

According to an embodiment of the three-dimensional arrangement of the first aspect, the scaffold structure comprises an electrical connection structure.

According to a second aspect of the present disclosure a method for fabricating a three-dimensional arrangement of nanoscopic devices comprises providing a scaffold structure and attaching a plurality of nanoscopic devices to the scaffold structure, the nanoscopic devices being configured to exhibit a nonreciprocal transmission probability of electron quantum wave packets, wherein attaching the nanoscopic devices to the scaffold structure is performed in such a way that a majority of the nanoscopic devices are oriented with one and the same transmission direction of the electron quantum wave packets.

According to an embodiment of the method for fabricating a three-dimensional arrangement of nanoscopic devices of the second aspect, the scaffold structure comprises one or more of a plurality of fibres or nanotubes, a plurality of sheets or foils, a plurality of graphene layers, or a plurality of semiconductor carriers.

According to an embodiment of the method for fabricating a three-dimensional arrangement of nanoscopic devices of the second aspect, attaching the plurality of nanoscopic devices in such a way that a symmetry-breaking process is applied to orient the nanoscopic devices along one and the same transmission direction of the electron quantum wave packets.

According to an embodiment of the method for fabricating a three-dimensional arrangement of nanoscopic devices of the second aspect, the method further comprises applying electrical contacts to the scaffold structure.

Further embodiments of the method for fabricating a three-dimensional arrangement of nanoscopic devices of the second aspect can be formed by combining it with any embodiment or feature described in connection with the three-dimensional arrangement of nanoscopic devices of the first aspect.

According to a third aspect of the present disclosure a use of a three-dimensional arrangement of nanoscopic devices according to the first aspect is provided for one or more of
- a device to achieve a deviation from the zeroth or the second law of thermodynamics;
- to shift a system out of the state of thermal equilibrium;
- to generate temperature and/or voltage differences within one body or between several bodies;
- to transport particles, information, momentum, angular momentum, charge, magnetic moment, or energy;
- to generate electric currents and/or electric power.

Further embodiments of the use of a three-dimensional arrangement of nanoscopic devices can be formed by combining it with any embodiment or feature described in connection with the three-dimensional arrangement of nanoscopic devices of the first aspect.

### BRIEF DESCRIPTION OF THE DRAWINGS

The accompanying drawings are included to provide a further understanding of examples and are incorporated in and constitute a part of this specification. The drawings illustrate examples and together with the description serve to explain principles of examples. Other examples and many of the intended advantages of examples will be readily appreciated as they become better understood by reference to the following detailed description.
Fig. 1 comprises Fig. 1a to 1g and shows a sketch of a nanoelement (a) and different implementations of nanoelements (b to g).
Fig. 2 shows a schematic perspective view of an arrangement comprising a fibre as the scaffold element and a molecule as the nanoelement attached to the fibre.
Fig. 3 shows a schematic perspective view of an arrangement comprising a fibre as the scaffold element and several molecules as the nanoelements attached to the fibre.
Fig. 4 shows a schematic perspective view of an arrangement comprising a fibre as the scaffold element and a plurality of molecules as the nanoelements attached to the fibre.
Fig. 5 comprises Fig. 5(a) to Fig. 5(d) and shows a perspective view on an arrangement of several scaffold elements with attached molecules (a), and representations of arrangements in which the scaffold structure is formed by an electrical connection structure (b to d).
Fig. 6 shows a sketch illustrating a compound structure including a thermal conductor providing thermal coupling to an outside heat bath.

### DETAILED DESCRIPTION

In the following description the terms "coupled" and "connected", along with derivatives may be used. It should be understood that these terms may be used to indicate that two elements co-operate or interact with each other regardless whether they are in direct physical or electrical contact, or they are not in direct or physical or electrical contact with each other which means that there can be one or more intermediate elements between the two elements.

When describing a nanoelement or nanoscopic device in the following, it should be noted that these terms are to be understood in a broad and extensive manner. Concerning its function it basically acts as a device comprising nonreciprocal transmission of electron quantum wave packets. Concerning its structure it can be understood as an artificial or man-made structure in which, for example, electrical wires or lines are fabricated by different technological methods. It can, however, also be understood as consisting of or comprising chemical components like, for example, molecules, molecule compounds, molecule rings like benzene rings, and so on. It furthermore can refer to solid compounds, e.g. with crystalline structures that exert the device function.

The term "nanoscopic" relates, for example, to an average size of the used devices in a three-dimensional arrangement in a range from 0.5 nm to 1000 nm. In particular, the average size of chemical components like the above-mentioned molecules, molecule compounds, molecule rings like benzene rings can be in a range from 0.5 nm to 50 nm or larger. On the other hand, the average size of technologically fabricated quantum devices in the form of, for examples, electrical wires or lines can be in a range from 2 nm to 200 nm or larger.

It should further be emphasized that in the embodiments of three-dimensional arrangements of nanoscopic devices shown and described in the following, no external voltage or current needs to be applied to any one of the single devices or to the arrangement as a whole. The device then rather functions itself, in particular as a source of voltage, current, or order or in a loss-free and/or non-superconducting and/or non-Josephson conducting manner as a conductor for currents. More generally speaking, in this case there are no required external forces driving the particles into the devices besides a heat bath having a temperature T > 0 K. It is, however, also possible to apply an external voltage or current or temperature gradient to at least one of the devices.

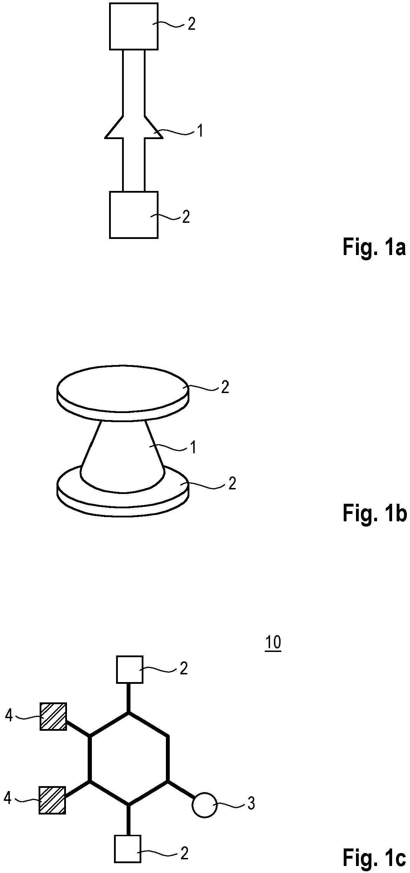

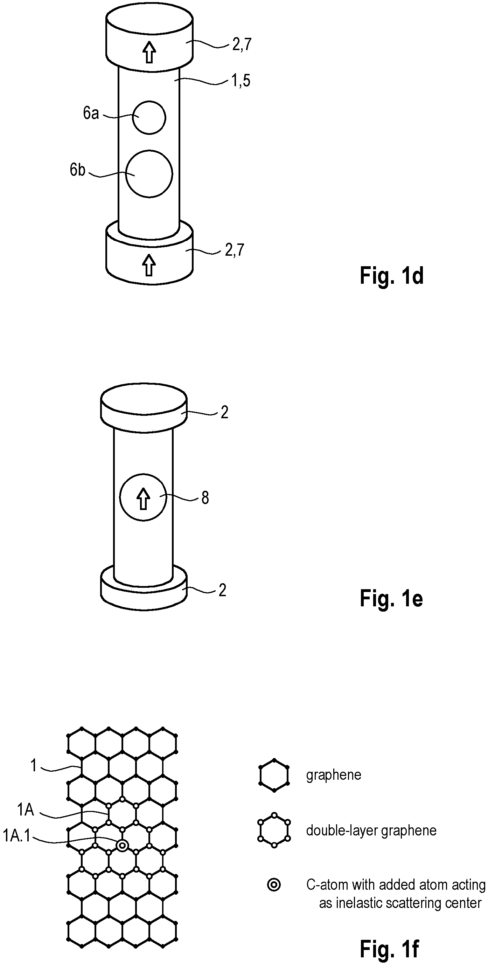

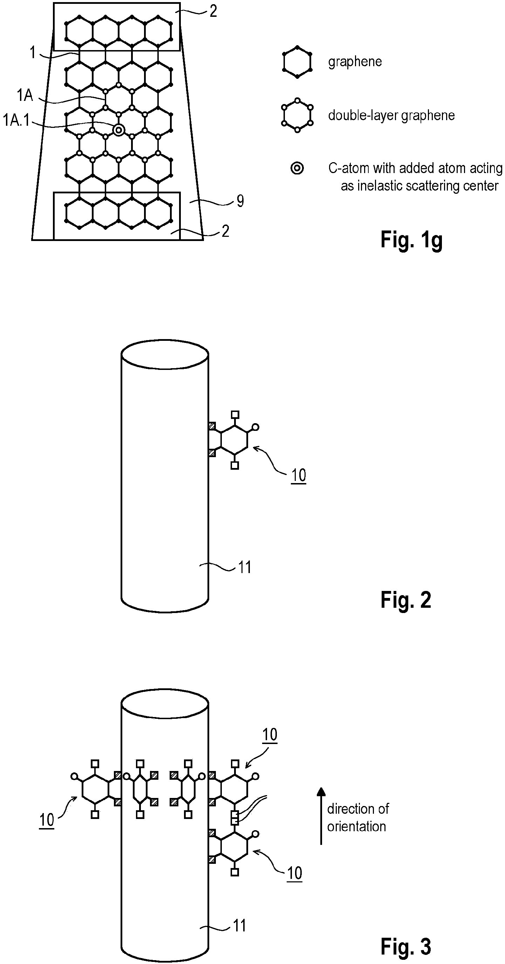

Fig. 1 comprises Fig. 1a to 1g and shows a sketch of a nanoscopic device (a) and different implementations of nanoscopic devices (b to g).

In particular, Fig. 1(a) shows a schematic sketch of a nanoscopic device which comprises an electrical conductor 1 and electrical contacts 2 connected to opposing ports of the electrical conductor 1. The electrical conductor 1 is characterized by a nonreciprocal transmission of electron quantum wave packets which in this case is enabled by the arrow-shape of the conductor. The electrical conductor 1 comprises a lower input port and an upper output wherein a first electrical contact 2 is connected to the lower input port and a second electrical contact 2 is connected to the upper output port. The electron quantum wave packets are emitted from the first electrical contact 2 in the direction of the second electrical contact 2 and vice versa. The quantum device is constructed in such a way that a net current of the electronic wave packets results in the direction from the first electrical contact to the second electrical contact. The movement of the electron wave packets results from extraction of thermal energy from the external heat bath.

The nanoscopic devices can in principle be any one of those electronic devices which were described in one of the above-mentioned Patent Applications [Mannhart_001] to [Mannhart_004]. A few more examples of nanoscopic devices will be given in the following Figs. 1(b) to 1(g) .

Fig. 1(b) shows a nanoscopic device as a possible realization of the quantum device according to (a).

The quantum device as shown in Fig. 1(b) comprises an electrical conductor 1 such as fabricated on the basis of a semiconductor, e.g., silicon, which comprises inelastic scattering centres and is shaped into a conical structure which tapers in the direction from the input port to the output port of the electrical conductor 1. In other words, the base of the cone is located on the first electrical contact. It may be a cone tapering to a point at the top or a truncated cone, in either case the top of the cone being located below the second electrical contact. The cone shown in Fig. 1(b) is a circular cone. However, other geometric shapes are also conceivable, such as a pyramid, a truncated pyramid, a tetrahedron or an obelisk.

Fig. 1(c) shows a sketch of a molecule used as a nanoelement.

The quantum device as shown in Fig. 1(c) comprises a ring molecule 10 like, for example, a benzene ring 10. As is well known, the basic structure of a benzene ring 10 consists of 6 carbon atoms, which are connected to each other in a ring shape. Each carbon atom has four valence electrons, two of which connect the atom to the neighbouring C atoms. Instead of the hydrogen atoms of the benzene ring 10, the molecule 10 of Fig. 1(b) contains two electrical contacts 2, two side groups 4 for attaching the molecule to a scaffold element, and a side group 5 to bring about symmetry breaking.

The symmetry breaking is generated as follows. As described by the Schrödinger equation, the electrons in the molecules or in nanodevices form electron waves (for atoms these would be the s, p, d orbitals ...). The electron waves propagate over all places which can be occupied by them, thus also over atoms or side groups which were added to a molecule, if the corresponding energy levels fit. Therefore, if an electron is offered an asymmetric molecule, as a rule the electron states and the evolution in time of wave-packets formed from these states are also asymmetric. This is what is desired. Therefore, as a simple example, the side group 5 is included in the intrinsically ring-shaped molecule of Fig. 1b for explanation.

Other ways to achieve asymmetric electron states include, for example, giving the molecule itself an asymmetric shape, e.g., a triangular shape or the like, choosing a molecule with a symmetric shape but in which the atomic sites in the molecule are occupied asymmetrically by several kinds of atoms or ions, or, as already mentioned, using man-made nanoelements.

Fig. 1(d) shows a sketch of a nanodevice consisting of a nanotube that contains two different atoms and inelastic scattering centres.

The quantum device as shown in Fig. 1(d) comprises an electrical conductor 1 in the form of a nanotube 5, at least two different atoms or ions 6a, 6b attached to or embedded into the nanotube 5, wherein the at least two different atoms 6a, 6b are used for symmetry breaking. The quantum device of Fig. 1(d) further comprises two electrical contacts 2 in the form of magnetic, dielectric, or ferroelectric components 7 used to orient the nanoelement in a direction as indicated by the arrows.

Fig. 1(e) shows a sketch of a nanodevice in the form of a nanotube analog to (d).

The quantum device as shown in Fig. 1(e) comprises an electrical conductor 1 in the form of a nanotube 5 containing inelastic scattering centres. Furthermore, in this implementation, a ferroelectric particle 8 is attached to or embedded into the nanotube 5 to simultaneously break the reciprocity of the electron transport and to provide a means to orient the nanotube 5 as indicated by the arrow.

Fig. 1(f) shows a sketch of a nanodevice comprising a graphene sheet.

The quantum device as shown in Fig. 1(f) comprises an electrical conductor 1 in the form of a graphene sheet 1 in which the reciprocity for electron transport is broken by incorporating a triangular-shaped section 1A that comprises a double-layer graphene. Furthermore, an inelastic scattering site in the form of an additional atom 1A.1 which has been added to a C-atom. Those carbon atoms that form the triangular-shaped section 1A are drawn enlarged, with the central C atom with the added atom drawn even slightly larger.

Fig. 1(g) shows a sketch of a nanodevice comprising a graphene sheet attached to an asymmetrically-shaped carrier.

The quantum device as shown in Fig. 1(g) comprises a nanodevice according to (f) in which the graphene sheet 1 is attached to an asymmetrically-shaped carrier 9 and supplied with electrical contacts 2. The asymmetry is created by the carrier 9 tapering towards the top of the quantum device.

Fig. 2 shows a schematic perspective view of an arrangement comprising a fibre as the scaffold element and a molecule as the nanoelement attached to the fibre.

The arrangement as shown in Fig. 2 comprises a scaffold element 11 in the form of a fibre 11 and a nanoelement 10 in the form of a molecule 10 attached to the fibre 11. The molecule 10 can be the one which has been shown and described above in connection with Fig. 1(c).

Fig. 3 shows a schematic perspective view of an arrangement comprising a fibre as the scaffold element and several molecules as the nanoelements attached to the fibre.

The arrangement as shown in Fig. 3 comprises a scaffold element 11 in the form of a fibre 11 and several nanoelements 10 in the form of molecules 10 attached to the fibre 11. The orientation of the molecules 10 along the fibre axis is preserved and indicated by the arrow. The two molecules 10 on the right side are shown to make an electrical contact via their contact ends 2.

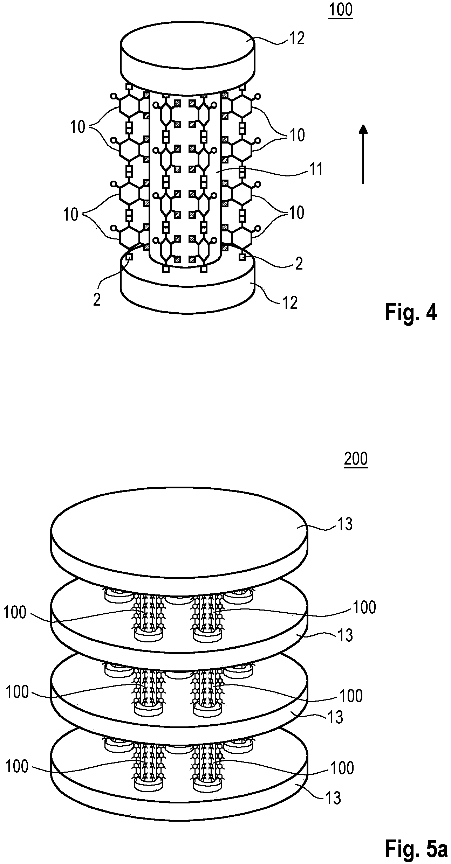

Fig. 4 shows a schematic perspective view of an arrangement comprising a fibre as the scaffold element and a plurality of molecules as the nanoelements attached to the fibre.

The arrangement 100 as shown in Fig. 4 comprises a scaffold element 11 in the form of a fibre 11 and a plurality of nanoelements 10 in the form of molecules 10 attached to the fibre 11. The orientation of the molecules 10 along the fibre axis is preserved and indicated by the arrow. The arrangement 100 comprises two electrical contacts 12 attached to the top and the bottom of the fibre, respectively. The lowermost molecules 10 are connected with their respective lowermost contacts 2 with the lower electrical contact 12 and the uppermost molecules 10 are connected with their respective uppermost contacts 2 (not to be seen in this representation) with the upper electrical contact 12. All other molecules 10 are connected between two neighbouring other molecules.

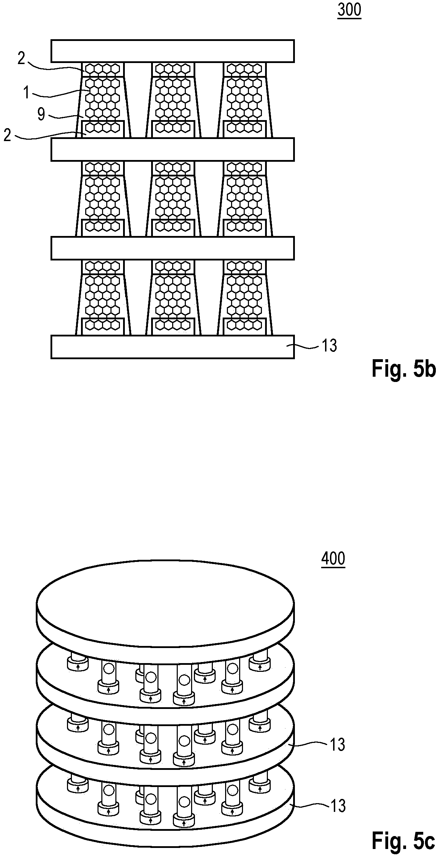

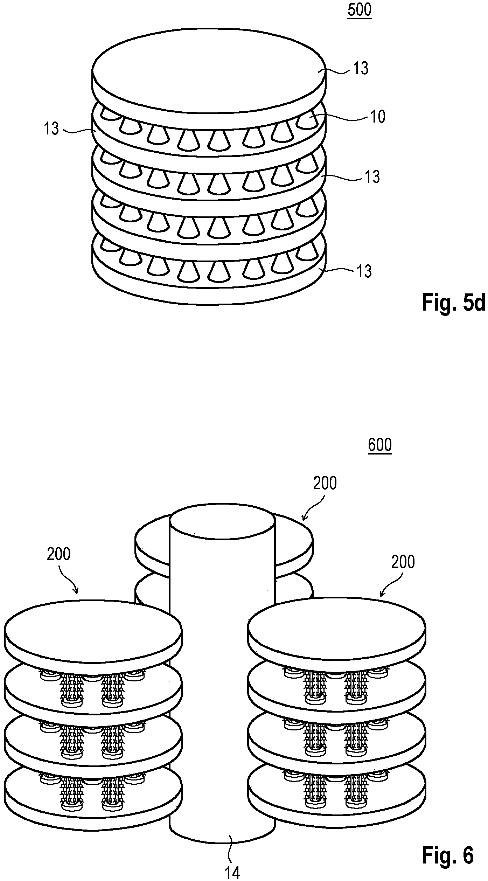

Fig. 5 comprises Fig. 5(a) to Fig. 5(d) and shows sketches of different embodiments of three-dimensional arrangements of nanoscopic devices.

Fig. 5 comprises Fig. 5(a) to Fig. 5(d) and shows a perspective view on an arrangement of several scaffold elements with attached molecules (a), and representations of arrangements in which the scaffold structure is formed by an electrical connection structure (b to d).

The arrangement 200 as shown in Fig. 5(a) shows bundles of several scaffold elements 100 in the form of fibres with attached nanoelements in the form of molecules. The scaffold elements 100 can be constructed in the same way as was shown and described in connection with Fig. 4. Electrical contacts in the form of plates 13 are used to provide for a parallel connection and series connection of the scaffold elements. The plates 13 comprise an uppermost plate 13, a lowermost plate 13, and two intermediate plates 13.

Fig. 5(b) to Fig. 5(d) show representations of arrangements in which the scaffold structure is formed by an electrical connection structure.

The arrangement 300 as shown in Fig. 5(b) shows several nanoelements such as those which were shown and described in connection with Fig. 1(g), namely a graphene layer 1 attached to an asymmetrically-shaped carrier 9 and supplied with electrical contacts 2. These nanoelements are directly connected to electrical contacts in the form of plates 13. The plates 13 comprise an uppermost plate 13, a lowermost plate 13, and two intermediate plates 13. Thus in this embodiment the electrical connection structure itself consisting of the plates 13 serves as a scaffold structure.

The arrangement 400 as shown in Fig. 5(c) shows several nanoelements such as those which were shown and described in connection with Fig. 1(d), namely nanotubes. These nanoelements are directly connected to electrical contacts in the form of plates 13. The plates 13 comprise an uppermost plate 13, a lowermost plate 13, and two intermediate plates 13. Thus also in this embodiment the electrical connection structure itself consisting of the plates 13 serves as a scaffold structure. Of course, it is also possible to use in this embodiment nanotubes which were shown and described in connection with Fig. 1(e).

The arrangement 500 as shown in Fig. 5(d) shows several nanoelements 10 such as those which were shown and described in connection with Fig. 1(b), namely cones. These nanoelements 10 are directly connected to electrical contacts in the form of plates 13. The plates 13 comprise an uppermost plate 13, a lowermost plate 13, and two intermediate plates 13. Thus also in this embodiment the electrical connection structure itself consisting of the plates 13 serves as a scaffold structure.

Fig. 6 shows a sketch illustrating a compound structure including a thermal conductor providing thermal coupling to an outside heat bath.

The assembly as shown in Fig. 6 comprises three three-dimensional arrangements 200 such as those which were shown and described in connection with Fig. 5(a). These arrangements 200 are connected with their electrical plates 13 to and grouped around a central thermal conductor 14. The thermal conductor 14 can be fabricated from a highly heat-conductive material like a metal and serves for a thermal coupling to the outside heat bath.

### 1. Implementations using fibre-based scaffold elements

In this implementation, fibres such as nanotubes are used as scaffold elements. Three steps are required to fabricate the entire assembly. The order of the steps used in this description is not mandatory, parts of the steps or all steps may, for example, be performed in parallel.

In the deposition step (a), the nanoelements are deposited either on the fibres directly or onto fibres coated with functional buffer layers or buffer layer systems. In the example given, functionalized end groups of the nanoelements determine the side with which they are attached to a fibre.

The functioning of the assembly requires that the nanoelements are furthermore oriented with the correct polarity along the fibre axis. This step has to be performed such that the ends of the nanoelements form an electric contact either to another nanoelement or to a different conductor.

Therefore, in assembling the nanoelements, a symmetry-breaking process has to be applied to orient the molecules as the nanoelements along the fibre-axis. Application of magnetic fields, pressure gradients or electric field gradients, or particle bombardment, during the attachment of the nanoelements provide examples of means for this symmetry breaking. In addition, an appropriate surface structure of the fibre or of a buffer layer grown on the fibre can serve the same goal.

In the assembly step (b), a three-dimensional arrangement of the fibres has to be established. For this, the known techniques to fabricate nanotube forests (see, e.g., [Lettiere 2020]) are for example applicable. The assembly may also be performed by mechanically aligning and assembling the fibres into bundles, hereby keeping the fibre polarity.

In the deposition, assembly and contacting steps, the use of patterned or structured coatings of the fibres by a buffer layer (system) may be beneficial.

### 2. Implementations using substrate carriers scaffold elements

In this implementation, which is illustrated in Figs. 1f, 1g, 5b the nanoelements are deposited onto or are fixed to carriers, such as ultrathin Si wafers with an asymmetric shape, which serve as scaffold elements. The assembly of the nanoelements on their carriers is then performed in analog to the assembly described for device shown in Fig. 6a.

### 3. Implementations using sheet-based scaffold elements

In the deposition step (a), the nanoelements are assembled on the sheets using standard deposition techniques, such as a Langmuir-Blodgett deposition technique or growth by self-assembly. Like for the case of the fibres as described above, the surface of the sheets may be pre-prepared by depositing a buffer layer. And, also like for the case of the fibres as described above, the in-plane symmetry of the deposition process of the nanoelements of the sheet has to be broken to provide for a chosen polarity of the attached nanoelement. Here, also the surface orientation (viscinal cut) or the choice of a material with a crystalline structure that already carries the desired symmetry breaking may be used, aside from, for example, the application of magnetic fields, pressure gradients or electric field gradients, or particle bombardment.

An advantage may be gained by already equipping the sheet surfaces with patterned electric conductors and/or to equip the sheets with a thermally conducting structure, e.g., a thermally conducting layer attached to a sheet side or embedded into the sheet.

In the assembly step (b), the sheets with the attached nanodevices are formed into bulk three-dimensional structures, for example by folding, rolling, or stacking. The sheets are then electrically contacted (step (c)).

### 4. Implementations in which the scaffold structure is given by an electrical connection structure

In these implementations the nanoelements are designed such that they also supply the function of a scaffold element. For this, two examples are given. In the example illustrated in Fig. 5c, advantage is taken of the mechanical strength of individual nanotubes to assemble the structure shown in Fig. 5c. In this case, it may be useful, to add further scaffold elements as additional spacers between the contact elements 13. The example shown in Fig. 5d is analogous to that of Fig. 5c, except that the conically-shaped nanoelements shown in Fig. 1b are used.

### 5. Architecture of the assembled structure

The different assembly processes as described above offer themselves to optionally integrate thermal conductors to transport thermal energy between the nanodevices and the external heat bath such as shown in Fig. 6.

The architecture of the assembly of the scaffolds may be chosen such that the nanodevices are first electrically connected into modules. In a second step, these modules are electrically connected among each other such that a desired output impedance of the entire assembly is achieved.

The assembly process as described above in connection with fibres or sheets offers itself to optionally integrate thermal conductors to transport thermal energy between the nanodevices and the external heat bath. Furthermore, the architecture of the assembly of the scaffolds may be chosen such that the nanodevices are first electrically connected into modules. In a second step, these modules are electrically connected among each other such that a desired output impedance of the entire assembly is achieved.

While the present disclosure has been illustrated and described with respect to one or more implementations, alterations and/or modifications may be made to the illustrated examples without departing from the spirit and scope of the appended claims. In particular with regard to the various functions performed by the above described components or structures (assemblies, devices, etc.), the terms used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A three-dimensional arrangement (100) of nanoscopic devices, the arrangement comprising
- a scaffold structure (11); and
- a plurality of nanoscopic devices (10), the nanoscopic devices (10) being configured to exhibit nonreciprocal transmission probability of electron quantum wave packets, wherein
- the nanoscopic devices (10) are attached to the scaffold structure (11), wherein a majority of the nanoscopic devices (10) are oriented with one and the same transmission direction of the electron quantum wave packets.

2. The three-dimensional arrangement (100) according to claim 1, wherein
each one of the nanoscopic devices (10) comprises at least two contacts (2) and is configured to exhibit a nonreciprocal transmission probability of electron quantum wave packets between the two contacts (2).

3. The three-dimensional arrangement (100) according to claim 1 or 2, wherein
almost each one of the nanoscopic devices (10) is connected between two other nanoscopic devices (10).

4. The three-dimensional arrangement (100) according to claim 2 or 3, wherein
each one of the nanoscopic devices (10) being further configured to convert heat of the environment into a difference of the electrochemical potentials of the two contacts (2).

5. The three-dimensional arrangement (100) according to any one of claims 2 to 4, wherein
the two contacts (2) comprise a first contact (2) and a second contact (2), and the three-dimensional arrangement (100) further comprises
a non-reciprocal transmission structure connected between the two contacts (2) and configured to transmit the electron quantum wave packets in at least a partially phase-coherent manner from the first contact (2) to the second contact (2), and possibly from the second contact (2) to the first contact (2) .

6. The three-dimensional arrangement (100) according to any one of the preceding claims, wherein
the nonreciprocal transmission is present without the external application of a voltage or a current to one or both of the first and second terminals.

7. The three-dimensional arrangement (100) according to any one of the preceding claims, further comprising at least two electrical contacts (12) connected to opposing sides of the scaffold structure (11).

8. The three-dimensional arrangement (100) according to any one of the preceding claims, wherein
the scaffold structure (11) comprises 10⁶ or more, preferably 10¹⁵ or more nanoscopic devices (10).

9. The three-dimensional arrangement (100) according to any one of the preceding claims, wherein
the scaffold structure (11) comprises one or more of a plurality of fibres or nanotubes, a plurality of sheets or foils, a plurality of graphene layers, or a plurality of semiconductor carriers.

10. The three-dimensional arrangement according to any one of the preceding claims, wherein
the scaffold structure comprises an electrical connection structure.

11. A method for fabricating a three-dimensional arrangement of nanoscopic devices, the method comprising
- providing a scaffold structure; and
- attaching a plurality of nanoscopic devices to the scaffold structure, the nanoscopic devices comprising at least two contacts and being configured to exhibit a nonreciprocal transmission probability of electron quantum wave packets between the two contacts, wherein
attaching the nanoscopic devices to the scaffold structure is performed in such a way that almost each one of the nanoscopic devices is connected between two other nanoscopic devices, wherein all nanoscopic devices are oriented with one and the same transmission direction of the electron quantum wave packets.

12. The method according to claim 11, wherein
the scaffold structure comprises one or more of a plurality of fibres or nanotubes, a plurality of sheets or foils, a plurality of graphene layers, or a plurality of semiconductor carriers.

13. The method according to claim 11 or 12, wherein attaching the plurality of nanoscopic devices in such a way that a symmetry-breaking process is applied to orient the nanoscopic devices along one and the same transmission direction of the electron quantum wave packets.

14. The method according to any one of claims 11 to 13, further comprising
applying electrical contacts to the scaffold structure.

15. A use of a three-dimensional arrangement of nanoscopic devices according to any one of claims 1 to 11 for one or more of
- a device to achieve a deviation from the zeroth or the second law of thermodynamics;
- to shift a system out of the state of thermal equilibrium;
- to generate temperature and/or voltage differences within one body or between several bodies;
- to transport particles, information, momentum, angular momentum, charge, magnetic moment, or energy;
- to generate electric currents and/or electric power.

16. The use according to claim 15, wherein
the device operates at a temperature in the range of 1 mK - 4000 K.

17. The use according to claim 15 or 16, wherein
the energy distribution of the first or second waves is generated at least partially by thermal energy.

18. The use according to any one of claims 11 to 17, wherein the device charges a storage system for energy, waves or matter, for example a capacitor or a battery.
